# EUROPÄISCHE PATENTANMELDUNG

(11) **EP 2 422 614 A1**
(43) Veröffentlichungstag der Anmeldung: **29.02.2012**
(21) Anmeldenummer: 10174183.3
(22) Anmeldetag: 26.08.2010
(51) Int. Cl.: A01G 9/14, B32B 17/10, C08K 5/20, H01L 31/048

(54) **Weichmacherhaltige Folien auf Basis von Polyvinylacetal mit selektiver Durchlässigkeit für UV-Strahlung**

(71) Anmelder: Kuraray Europe GmbH, 65926 Frankfurt am Main (DE)
(72) Erfinder: Beekhuizen, Jan, Dr., 53844, Troisdorf (DE); Karpinski, Andreas, D-51519, Odenthal (DE); Keller, Uwe, Dr., D-53177, Bonn (DE)
(74) Vertreter: Kisters, Michael Marcus

(57) **Zusammenfassung**

Die Erfindung betrifft die Verwendung von weichmacherhaltigen, auf Polyvinylacetal basierenden Folien, unter Verwendung von UV-Absorbern vom Oxanilid-Typ der Formel (1).

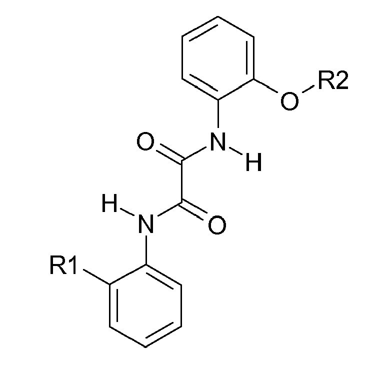

## Beschreibung

### Technisches Gebiet

Die Erfindung betrifft weichmacherhaltige Folien auf Basis von Polyvinylacetal mit selektiver Durchlässigkeit für UV-Strahlung und geringer Vergilbungsneigung sowie damit hergestellte Glaslaminate.

### Stand der Technik

Marktübliche weichmacherhaltige Polyvinylbutyral-Folie (PVB-Folie) für Verbundverglasungenen ist seit vielen Jahrzehnten mit UV-Absorbern ausgerüstet, damit UV-Strahlung im Gegensatz zum sichtbaren Licht das Verbundglas nicht durchdringen kann. Auf diese Weise kann auf einfache Art ein fast vollständiger Schutz vor schädigender UV-Strahlung für sich hinter dem Verbundglas befindliche Personen oder Objekte sichergestellt werden. Dies stellt neben dem Schutz vor Schnittverletzungen den wesentlichen Eigenschaftsvorteil gegenüber monolithischem Glas dar, da dieses für UV-Strahlung weitgehend transparent ist.

Für die Anwendung von PVB-Folien als Einkapselungsmaterial in Photovoltaikmodulen werden sogar erhöhte Mengen von UV-Absorbern verwendet, weil angenommen wird, dass durch die intensive Sonnenlichtexposition von Solarmodulen andernfalls Vergilbung der PVB-Folie die Folge sein könnte.

Besonders bewährt und verbreitet werden als UV-Absorber Abkömmlinge des 2-Hydroxyphenylbenzotriazols verwendet, welche mit verschiedenen Substitutionsmustern z.B. unter den Handelsnamen Tinuvin P, Tinuvin 328, Tinuvin 327, Tinuvin 326 erhältlich sind. UV-Absorber vom Benzotriazol-Typ sind in PVB-Folie für ihre herausragende Langzeitstabilität, gute Löslichkeit und hohe Absorptionsleistung im gesamten UV-Bereich (UV-B und UV-A) bekannt. Je nach Substitutionsmuster findet eine Absorption aber mehr oder weniger stark auch noch im sichtbaren Bereich des Spektrums statt, also z.B. bei 400 nm, so dass diese UV-Absorber je nach Einsatzmenge und Substituentenverteilung eine gewisse Gelbfärbung der PVB-Folie verursachen können.

Ist für die überwiegende Zahl der Einsatzmöglichkeiten von Verbundsicherheitsglas ein möglichst vollständiger Schutz vor UV-Strahlung - d.h. mehr als 99% Absorption - gefordert, gibt es spezielle Anwendungen, in denen eine hohe Durchlässigkeit für UV-Strahlung wünschenswert wäre:
- In Gewächshäusern zur Gemüse- oder Schnittblumenzucht wird eine möglichst hohe Energieeinstrahlung und eine Mindestmenge an UV-Strahlung benötigt. Zusätzlich orientieren sich die zur Bestäubung eingesetzten Insekten (Bienen, Hummeln) auch anhand von UV-Kontrasten.
- Bei Photovoltaikmodulen mit Zelltypen, welche zusätzlich zum sichtbaren Licht auch Anteile des UV-Spektrums zur Photostromerzeugung nutzen können und in welchen die PVB-Folie vor diesen auf der lichtzugewandten Seite angeordnet ist, fällt die Energieausbeute geringer aus, wenn die PVB-Folie bei Verwendung der üblichen UV-Absorber vom Benzotriazol-Typ für UV-Strahlung fast vollständig opak ist.
- Bei Anwendungen im Innenbereich, bei denen kein UV-Schutz nötig ist, kann eine erhöhte UV-Transmission zugelassen werden, um farbarme Elemente, insbesondere in Verbindung mit eisenarmen Glas farblich natürlicher erscheinen zu lassen, da UV-Stabilisierte PVB-Folie einen geringen Gelbwert des Verbundes mit sich bringt.
- Als UV-durchstrahlbares Verbundglas zu dessen Montage mit UV-A-härtenden Klebern, z.B. im Möbelglasbereich
- Als Teil einer Vogelschutzverglasung (d.h. zum Schutz der Vögel), bei welcher zur Erzielung eines für Vögel wahrnehmbaren Kontrastes eine mit der PVB-Folie laminierte Scheibe partiell UV-durchlässig sein soll.

### Aufgabe

Aufgabe der vorliegenden Erfindung war es, eine PVB-Folie mit geringer Vergilbungsneigung, hoher Transmission für UV-A-Strahlung (325 bis 400 nm) und sichtbares Licht bei gleichzeitig geringer Durchlässigkeit für UV-B-Strahlung (280 bis 325 nm) herzustellen.

Polyvinylbutyral ist ein aus gesättigten Einheiten aufgebautes Copolymer, d.h. es enthält olefinische oder aromatische Bindungen normalerweise allenfalls als Fehlstelle und weist aus diesem Grund auch keine nennenswerte Absorption im Wellenlängenbereich von 280 - 400 nm (UV-A + UV-B) auf. Des Weiteren werden zur Plastifizierung des PVB überwiegend nichtaromatische Weichmacher herangezogen, für welche bezüglich UV-Absorption entsprechendes gilt. Damit resultiert eine relativ hohe inhärente UV-Stabilität einer aus PVB und Weichmacher bestehenden Mischung zur Herstellung von Folien.

PVB kann in Abhängigkeit der Qualität der Ausgangsstoffe Polyvinylalkohol bzw. Butyraldehyd und der Prozessführung bei der Synthese und Aufarbeitung Fehlstellen bzw. Verunreinigungen enthal t e n , welche dessen U V-Stabilität beinträchtigen. Weiterhin können der Folienformulierung hinzugefügte Additive wie etwa Farbstoffe oder phenolische Antioxidantien UVempfindlich sein, so dass PVB-Folien üblicherweise einen UV-Absorber enthalten.

Das einfache Weglassen von UV-Absorbern hat den Nachteil, dass dann auch hohe Anteile an hochenergetischer UV-B Strahlung (280
- 325 nm) durchgelassen werden, was für Gewächshäuser je nach Pflanzenart unerwünscht sein kann, für Photovoltaikmodule Materialschädigung bewirken kann und für eine farbarme Verglasung keine weitere Reduzierung des Gelbwertes bringt.

Zusätzlich können phenolische Antioxidantien unter UV-Einfluss, insbesondere UV-B Strahlung, vergilben, wodurch sich dann der Gelbwert der Folie mit der Zeit erhöht und die Transmission im sichtbaren Bereich des Sonnenlichtspektrums abnimmt. Besonders die kommerziell bedeutendste Gruppe phenolischer Antioxidantien mit der Teilstruktur (2,5-di-tert-butyl-4-hydroxyphenyl)propionat, welcher unter anderem Produkte vom Typ Irganox 1010, Irganox 1076, Irganox 1035 angehören, führt bei Verwendung in PVB-Folie bei UV- und/oder Temperatureinwirkung im Glaslaminat zu Vergilbung.

Eine PVB-Folie gänzlich ohne UV-Absorber führt also nur bei Einhaltung bestimmter Randbedingungen insofern zum Erfolg, dass diese die für die jeweilige Anwendung unterschiedlich hohen Anforderungen an Dauerstabilität sicher erfüllt. Zusätzlich hat eine damit hergestellte Verglasung bzw. ein damit hergestelltes Photovoltaikmodul den Nachteil, dass die besonders schädliche UV-B Strahlung ungehindert durch die Verglasung bzw. in das PV-Modul dringen kann.

Überraschenderweise wurde gefunden, dass weichmacherhaltige Polyvinylacetalfolie in einer Weise hergestellt werden kann, dass sie ein geringe Vergilbungsneigung sowie hohe Transmission für UV-A Strahlung und sichtbares Licht bei gleichzeitig geringer Durchlässigkeit für UV-B Strahlung aufweist. Hierdurch kann bei Verwendung in Gewächshausverglasung deren direkter Strahlungstransmissionsgrad T_{E} (gemäß EN 410), bei Verwendung in Photovoltaikmodulen deren Photostromausbeute verbessert werden. Bei Verwendung in Photovoltaikmodulen, in denen sich die PVB-Folie auf der Licht zugewandten Seite vor den Zellen befindet, kann deren Photostromausbeute merklich erhöht werden, sofern die Zellen eine Empfindlichkeit im Wellenlängenbereich 325 bis 380 nm aufweisen. Bei Verwendung der UV-A durchlässigen PVB-Folie für besonders farbarme Verglasung kann deren Gelbstich reduziert werden, da die Folie im Wellenlängenbereich 380 bis 450 nm vollkommen transparent ist. Die Transparenz für UV-A Strahlung ermöglicht auch die Monatage von die PVB-Folie enthaltenen Verbundgläsern mit UV-A-härtenden Klebern, wobei das Verbundglas durch zur Härtung der Kleber benötigtes UV-A-Licht problemlos durchstrahlt werden kann. Weiterhin kann augrund der Transparenz für UV-A Strahlung leicht ein für Vögel wahrnehmbarer Kontrast im UV-Bereich erzeugt werden, z.B. indem die Folie partiell mit einem weiteren UV-Absorber, welcher zusätzlich den UV-A-Bereich abdeckt, bedruckt wird.

### Darstellung der Erfindung

Gegenstand der vorliegenden Erfindung ist daher eine weichmacherhaltige Folie enthaltend mindestens ein Polyvinylacetal und mindestens einen Weichmacher, gekennzeichnet durch den Zusatz von 0,001 bis 1 Gew.% mindestens einer Verbindung vom Oxanilid-Typ gemäß Formel 1 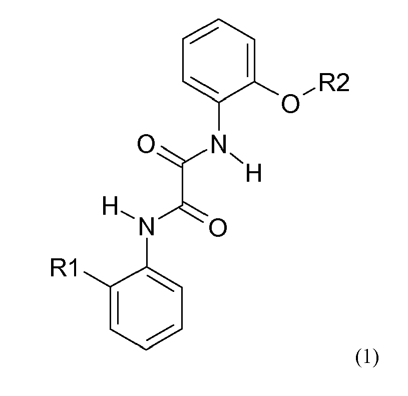 mit R1, R2 = Kohlenwasserstoffradikal mit 1 bis 10 Kohlenstoffatomen als UV-Absorber

Bevorzugt enthalten erfindungsgemäße Folien als Oxanilid-Verbindung gemäß Formel 1 2-Ethyl-2'-ethoxy-oxalanilid, CAS-Nr. 23949-66-8 als UV-Absorber. Dieser ist kommerziell z.B. von BASF (CIBA) als "Tinuvin 312", von SONGWON als "Songsorb 3120" oder von CLARIANT als "Sanduvor VSU" erhältlich.

Selbstverständlich können durch Variation der Substituenten auf einfache Weise weitere analoge Strukturen generiert werden, welche entsprechend im Rahmen der Erfindung eingesetzt werden können.

Bevorzugt enthalten erfindungsgemäße Folien UV-Absorber vom Oxanilid-Typ in einer Menge von 0,01 bis 0,75 Gew.%, bevorzugt 0,05 bis 0,50 Gew.% und am meisten bevorzugt 0,075 bis 0,35 Gew.%.

Erfindungsgemäßen Folien weisen in einer Dicke von 0.76 mm bei Messung gemäß EN 410 zwischen 2 x 2 mm eisenarmes Floatglas bei 380 nm eine Transmission größer 50%, bevorzugt größer 70%, bevorzugt mehr als 80% und besonders bevorzugt größer 85% auf. Gleichzeitig ist die Transmission solcher Laminate bei 325 nm kleiner 50%, bevorzugt kleiner 30% und besonders bevorzugt kleiner 20%.

Der direkte Strahlungstransmissionsgrad T_{E} erhöht sich gegenüber einer mit einem herkömmlich verwendeten UV-Absorber vom Benzotriazol-Typ (Tinuvin 328) ausgerüsteten Folie von ca. 82,5% auf über 84%, was bei z.B. bei Gewächshausverglasungen von Vorteil ist.

Zur Thermischen Stabilisierung der PVB-Folienmasse gegen Kettenabbau insbesondere während des Extrusionsprozesses werden unabhängig vom Vorliegen eines UV-Absorbers phenolische Antioxidantien benötigt.

Da bei Verwendung der UV-Absorber vom Oxanilid-Typ der höhere Anteil an UV-A Strahlung zur Vergilbung der Folie durch bestimmte phenolischen Antioxidantien führen kann, sind bevorzugt solche zu verwenden, welche nicht eine Teilstruktur (2,5-di-tert-butyl-4-hydroxyphenyl)propionat beinhalten. Es ist möglich, Antioxidantien mit der Teilstruktur (2,5-di-tert-butyl-4-hydroxyphenyl)propionat nur in geringem Anteil, d.h. bevorzugt zu nicht mehr als 1000 ppm, bevorzugt zu nicht mehr als 500 ppm, bevorzugt zu nicht mehr als 250 ppm und am meisten bevorzugt zu nicht mehr als 100 ppm in der Folie einzusetzen.

Geeignete Antioxidantien, welche die Teilstruktur (2,5-di-tert-butyl-4-hydroxyphenyl)propionat nicht enthalten, können dagegen in einer Menge von 0,005-0,5 Gew.% in der Folie enthalten sein. Geeignete Antioxidantien, welche die Teilstruktur (2,5-di-tert-butyl-4-hydroxyphenyl)propionat nicht enthalten sind z.B. zweikernige phenolische Antioxidantien vom Typ Lowinox 44B25 oder Irganox 129, einkernige vom Typ Songsorb 2908 (CAS: 67845-93-6), BHT (CAS: 128-37-0), p-Octylphenol, mehrkernige wie z.B. Topanol CA (CAS: 1843-03-4) oder Wingstay L (31851-03-3). Ebenfall kommen phenolische Antioxidantien in Betracht, welche ein oder mehrere Schwefelatome enthalten, jedoch die Teilstruktur (2,5-di-tert-butyl-4-hydroxyphenyl)propionat nicht enthalten.

Besonders bevorzugt enthalten die erfindungsgemäßen Folien neben dem UV-Absorber vom Oxanilid-Typ ein oder mehrere phenolische Antioxidantien, welche die Teilstruktur (3-tert-butyl-4-hydroxy-5-methylphenylpropionat gemäß Formel (2), (3) oder (4) aufweisen. 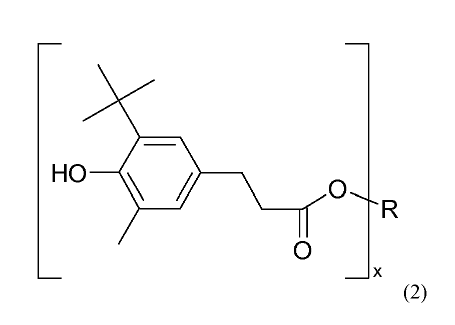 Geeignete Stabilisatoren der Formel (2) sind zum Beispiel solche der Formel (3) 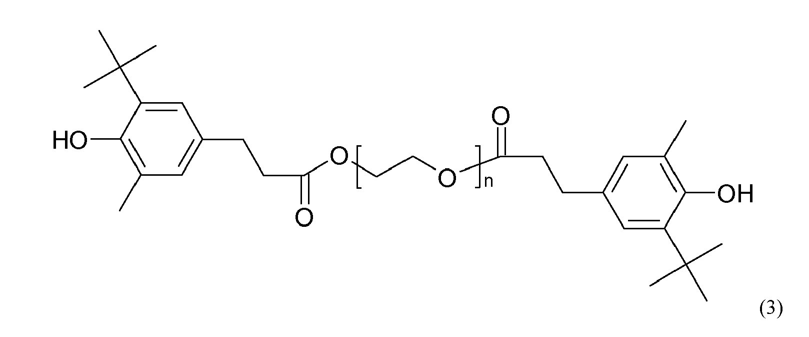 mit n=1 bis 10 oder solche der Formel 4

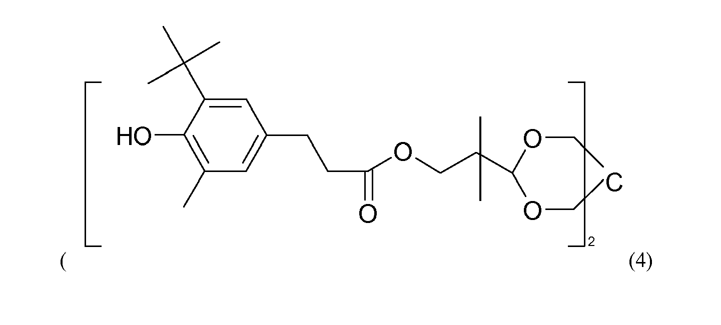

Geeignete Stabilisatoren gemäß Formel (2), (3) oder (4) sind solche der CAS-Reg.Nr. 36443-68-2, welche beispielsweise von der Firma CIBA als IRGANOX 245, von der Firma CHEMTURA als Lowinox GP45 oder von der Firma SONGWON als Songnox 2450 sowie solche der CAS-Reg.Nr. 90498-90-1 die unter dem Namen Sumilizer GA 80 von der Firma SUMITOMO erhältlich sind.

Erfindungsgemäße Mischungen oder Folien enthalten bevorzugt 0,005 - 0,5 Gew.-%, besonders bevorzugt 0,01 - 0,25 Gew.-%, insbesondere 0,02 - 0,1 Gew.-% und am meisten bevorzugt 0,03 - 0,08 Gew.-% der phenolischen Antioxidantien mit der Teilstruktur 3-t-Butyl-4-hydroxy-5-methylphenylproprionat gemäß Formel (2), (3) oder (4).

Zusätzlich zur Verwendung der phenolischen Antioxidantien mit der Teilstruktur 3-t-Butyl-4-hydroxy-5-methylphenylproprionat gemäß Formel (2), (3) oder (4) können die thermoplastischen Mischungen/Folien eine Grundstabilisierung mit einem weiteren photostabilen, aufgrund anderer Eigenschaften, wie etwa hoher Flüchtigkeit, für sich alleine genommen weniger geeignetem phenolischen Antioxidants enthalten. Im Rahmen der vorliegenden Erfindung sind damit Antioxidantien mit einer erhöhten Flüchtigkeit unter den Extrusions- und Verarbeitungsbedingungen von PVB-Folie gemeint, was auf phenolische Antioxidantien mit einem Molekulargewicht von weniger als 300 g/mol in der Regel zutrifft. Bevorzugt enthalten die erfindungsgemäßen thermoplastische Mischung bzw. Folien phenolische Antioxidantien mit einem Molekulargewicht von weniger als 300 g/mol in einer Menge von 0.001 - 0.25 Gew.-% (bezogen auf die Folienmischung). Besonders geeignete phenolische Antioxidantien mit einem Molekulargewicht von weniger als 300 g/mol sind BHT (CAS-Reg.Nr.: 128-37-0) oder 4-tert-Octylphenol (CAS-Reg.Nr.: 140-66-9).

Die genannten phenolische Antioxidantien mit Molekulargewicht von weniger als 300g/mol können in der angegebenen Menge alleine oder in Kombination mit einem anderen phenolischen Antioxidants verwendet werden.

Zusätzlich zur Verwendung der Oxanilid-UV-Absorber kann die Einstellung eines geringen Alkalititers der erfindungsgemäßen Mischung z.B. bei der Neutralisation des Polyvinylacetal verbesserte Eigenfarbe und photothermische Stabilität der erfindungsgemäßen Folie bewirken.

Der Alkalititer wird, wie in den Beispielen angegeben, durch Neutralisation der erfindungsgemäßen Mischung bzw. Folie mit Salzsäure bestimmt und liegt bevorzugt zwischen 2 und 70, insbesondere zwischen 3 und 50 und am meisten bevorzugt zwischen 5 und 30.

Die Einstellung des Alkalititers kann durch entsprechende Neutralisation des Polyvinylacetals während oder nach dessen Herstellung durch Acetalisierung von Polvinylalkohol erfolgen oder durch Zugabe von Metallsalzen zur erfindungsgemäßen Mischung. Die Metallsalze fungieren bei der Verwendung der erfindungsgemäßen Folien für Verbundglaslaminate in der Regel auch als Antihaftmittel.

Erfindungsgemäße Folien können als Antihaftmittel Erdalkalimetall-, Zink-, Aluminium- bzw. Alkalimetallionen enthalten. Diese liegen in der Mischung/Folie in Form der Salze von ein- oder mehrwertigen anorganischen oder ein- oder mehrwertigen organischen Säuren vor. Beispiele für Gegenionen sind z.B. Salze organischer Carbonsäuren wie etwa Formiate, Acetate, Trifluoracetate, Propionate, Butyrate, Benzoate, 2-Ethylhexanoate usw., wobei bevorzugt Carbonsäuren mit weniger als 10 C-Atomen, bevorzugt weniger als 8, bevorzugt weniger als 6, bevorzugt weniger als 4 und besonders bevorzugt mit weniger als 3 C-Atomen verwendet werden. Beispiele für anorganische Gegenionen sind Chloride, Nitrate, Sulfate, Phosphate. Weitere Gegenionen können den Tensiden zuzurechnende Anionen sein, wie etwa Sulfonate oder Phosphatische Tenside.

Bevorzugt enthält die erfindungsgemäße Folie mehr als 5 ppm, bevorzugt mehr als 10 ppm, bevorzugt mehr als 15 ppm, bevorzugt mehr als 20 ppm, bevorzugt mehr als 25 ppm Ionen ausgewählt aus der Gruppe der Erdalkalimetalle (Be, Mg, Ca, Sr, Ba, Ra), Zink und Aluminium. Um unerwünschte Trübung zu vermeiden, sollten andererseits aber nicht mehr als 250 ppm der genannten mehrwertigen Metalle enthalten sein.

Gleichzeitig ist der Gehalt an Alkalimetallionen (Li, Na, K, Rb, Cs, Fr) in der weichmacherhaltigen, auf Polyvinylacetal basierenden Folie möglichst niedrig einzustellen. Bevorzugt enthält die Folie weniger als 150 ppm, bevorzugt weniger als 100 ppm, bevorzugt weniger als 75 ppm, bevorzugt weniger als 50 ppm, bevorzugt weniger als 25 ppm, bevorzugt weniger als 10 ppm und besonders bevorzugt weniger als 5 ppm Alkalimetallionen.

Die erfindungsgemäß eingesetzten Polyvinylacetale sind als Acetalisierungsprodukte von Polyvinylalkohol PVA mit Aldehyden wie Butyraldehyd erhältlich. Erfindungsgemäße Folien können ein oder mehrere Polyvinylacetale enthalten, die sich in Molgewicht, Acetalisierungsgrad, Restalkoholgehalt oder Anzahl der Kohlenstoffatome der Acetalgruppe unterscheiden können.

Weiterhin können die genannten günstigen optischen Eigenschaften der erfindungsgemäßen Folie durch Selektion des zur Herstellung des Polyvinylacetals herangezogenen Polyvinylalkohol (PVA) verbessert werden. Liegen auf Stufe des PVA ungesättigte Einheiten in der Polymerkette als Fehlstellen vor, finden sich diese zwangsläufig auch im daraus erzeugten Polyvinylacetal wieder wodurch sich dessen Absorption von UV-Strahlung erhöht und Lichtstabilität verschlechtert. Die ungesättigten Einheiten können in Form von isolierten oder in Konjugation zueinander oder in Konjugation zu Carbonylbindungen stehenden Doppelbindungen vorliegen. Diese ungesättigten Einheiten lassen sich durch UV-Spektroskopie im PVA nachweisen.

Sehr hohe Anteile an Fehlstellen führen bei Messung des eingesetzten PVA in 4 Gew.%-iger Lösung in H₂O zu Extinktionen bei 280 nm von nahe 1. Zur Herstellung von erfindungsgemäß verwendetem Polyvinylacetal werden daher bevorzugt Polyvinylalkohole eingesetzt, die in einer 4 Gew.% wässrigen Lösung bei 280 nm Extinktionswerte von weniger als 0.5, von weniger als 0.3, insbesondere 0.2 und bevorzugt 0.1 aufweist.

Zusätzlich zu der Verwendung eines für UV-A Strahlung weitgehend transparenten UV-Absorbers vom Oxanilid-Typ und der Verwendung von nicht zum Vergilben neigenden phenolischen Antioxidantien und/oder der Verwendung von besonders Fehlstellenarmen Polyvinylacetalen und/oder der Einstellung des Alkalititers können die erfindungsgemäß hergestellten Folien mit einem oder mehreren nicht-aromatischen Lichtstabilisatoren, insbesondere mit sterisch gehinderten Aminen vom Typ HALS und/oder sterisch gehinderten Aminoethern (NOR-HALS) ausgerüstet werden.

Erfindungsgemäße Folien enthalten bevorzugt 0,005 - 1 Gew.-%, besonders bevorzugt 0,01 - 0,5 Gew.-%, insbesondere 0,03 - 0,3 Gew.-% und am meisten bevorzugt 0,05 - 0,25 Gew.-% sterisch gehinderte Amine vom HAS, HALS oder NOR-HALS Typ als Lichtstabilisatoren.

Besonders geeignete sterisch gehinderte Amine sind solche der allgemeinen Formeln (5), (6) und/oder (7). 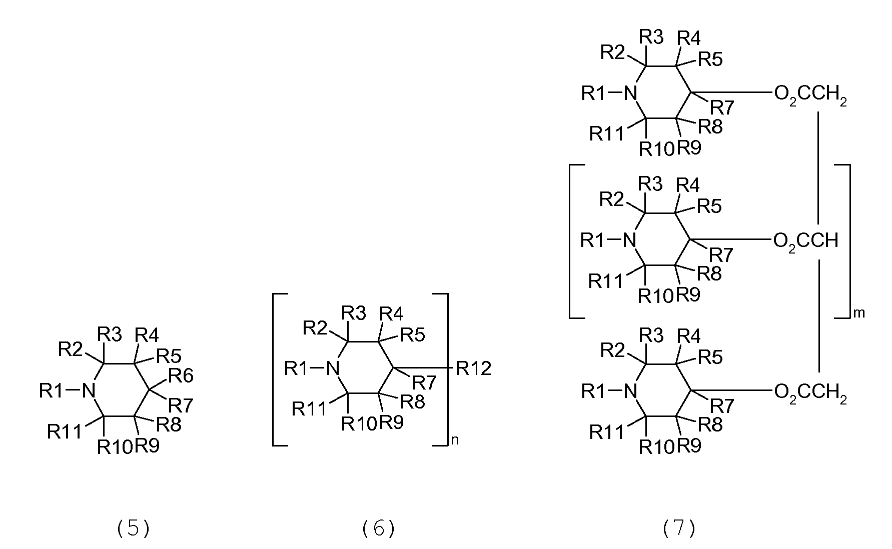 mit R1, R2, R3, R4, R5, R6, R7, R8, R9, R10, R11 = wie H, C1 - C20 Alkyl, Hydroxyalkyl, Alkoxyalkyl, Acyloxyalkyl, jeweils unsubstituiert oder durch Aldehyd-, Keto- oder Epoxidgruppen substituiert
R12 = glatte Verbindung, C1 - C20 Alkyl, Hydroxyalkyl, Alkoxyalkyl, Acyloxyalkyl, jeweils unsubstituiert oder durch Aldehyd-, Keto- oder Epoxidgruppen substituiert
n = 2 - 4
m = 1 - 10.

Verbindungen dieser Art sind kommerziell erhältlich, beispielsweise durch die Produkte Tinuvin 123 (NOR-HALS), Tinuvin 144, Tinuvin 622, Tinuvin 770 sowie dessen Di-N-methyliertes Derivat der BASF (Ciba Specialities). Besonders gut geeignet sind beispielsweise Songlight 2920 der Firma Songwon International, ADK Stab LA-57, LA-52 oder LA-62 der Fa. Asahi Denka Co. oder UVINUL 4050 H der BASF SE.

Zur Herstellung von Polyvinylacetal wird Polyvinylalkohol in Wasser gelöst und mit einem Aldehyd wie z.B. Butyraldehyd, Formaldehyd oder Propionaldehyd unter Zusatz eines Säurekatalysators acetalisiert. Das ausgefallene Polyvinylacetal wird abgetrennt, neutral gewaschen, ggf. in einem alkalisch eingestellten wässrigen Medium suspendiert, danach erneut neutral gewaschen und getrocknet.

Die zur Acetalisierung eingesetzte Säure muss nach erfolgter Reaktion wieder neutralisiert werden. Ein geringer Gehalt an Alkalimetallionen kann unter anderem bei der Synthese des Polyvinylacetals durch Verzicht auf die üblicherweise zur Neutralisation des Katalysators angewandten Natrium- oder Kaliumhydroxide bzw. Carbonate oder durch gründliches Waschen des bei der Acetalisierung erhaltenen Polyvinylacetals erzielt werden. Alternativ zu den Basen NaOH oder KOH, kann die Katalysatorsäure aus dem Acetalisierungsschritt z.B. durch Einblasen von Kohlendioxid oder Ethylenoxid neutralisiert werden.

Der Polyvinylalkoholgehalt des Polyvinylacetals kann durch die Menge des bei der Acetalisierung eingesetzten Aldehyds eingestellt werden.

Es ist auch möglich, die Acetalisierung mit anderen oder mehreren Aldehyden mit 2-10 Kohlenstoffatomen (z.B. Valeraldehyd) durchzuführen.

Die auf weichmacherhaltigem Polyvinylacetal basierenden Folien enthalten bevorzugt unvernetztes Polyvinylbutyral (PVB), das durch Acetalisierung von Polyvinylalkohol mit Butyraldehyd gewonnen wird.

Der Einsatz von vernetzten Polyvinylacetalen, insbesondere vernetztem Polyvinylbutyral (PVB) ist ebenso möglich. Geeignete vernetzte Polyvinylacetale sind z.B. in EP 1527107 B1 und WO 2004/063231 A1 (thermische Selbstvernetzung von Carboxylgruppenhaltigen Polyvinylacetalen), EP 1606325 A1 (mit Polyaldehyden vernetzte Polyvinylacetale) und WO 03/020776 A1 (mit Glyoxylsäure vernetzte Polyvinylacetale) beschrieben. Auf die Offenbarung dieser Patentanmeldungen wird vollumfänglich Bezug genommen.

Als Polyvinylalkohol können im Rahmen der vorliegenden Erfindung auch Terpolymere aus hydrolysierten Vinylacetat/Ethylen-Copolymeren eingesetzt werden. Diese Verbindungen sind in der Regel zu mehr als 98 Mol% hydrolysiert und enthalten 1 bis 10 Gew. auf Ethylen basierende Einheiten (z.B. Typ "Exceval" der Kuraray Europe GmbH).

Als Polyvinylalkohol können im Rahmen der vorliegenden Erfindung weiterhin auch hydrolysierte Copolymere aus Vinylacetat und mindestens einem weiteren ethylenisch ungesättigten Monomer eingesetzt werden.

Die Polyvinylalkohole können im Rahmen der vorliegenden Erfindung rein oder als Mischung von Polyvinylalkoholen mit unterschiedlichem Polymerisationsgrad oder Hydrolysegrad eingesetzt werden.

Polyvinylacetale enthalten neben den Acetaleinheiten noch aus Vinylacetat und Vinylalkohol resultierende Einheiten. Die erfindungsgemäß verwendeten Polyvinylacetale weisen bevorzugt einen Polyvinylalkoholanteil von weniger als 22 Gew.%, 20 Gew.% oder 18 Gew.%, weniger als 16 Gew.% oder 15 Gew.% und insbesondere weniger als 14 Gew.% auf. Ein Polyvinylalkoholanteil von 12 Gew.% sollte nicht unterschritten werden.

Der Polyvinylacetatgehalt des erfindungsgemäß eingesetzten Polyvinylacetals liegt bevorzugt unter 5 Gew.%, unter 3 Gew.% oder unter 1 Gew.%, besonders bevorzugt unter 0,75 Gew.%, ganz besonders bevorzugt unter 0,5 Gew.% und insbesondere unter 0,25 Gew.%.

Aus dem Polyvinylalkoholanteil und dem Restacetatgehalt kann der Acetalisierungsgrad rechnerisch ermittelt werden.

Bevorzugt weisen die Folien einen Gesamtweichmachergehalt d.h. der Anteil aller Weichmacher in der Folie im Bereich von 5 - 45 Gew.%, 12 - 36 Gew. %, 14 - 32 Gew.%, 16 - 30 Gew. %, insbesondere 20 - 28 Gew.% auf. Erfindungsgemäße Folien bzw. damit verklebte Laminate / Module können einen oder mehrere Weichmacher enthalten.

Gut geeignet als Weichmacher für die erfindungsgemäßen Folien sind eine oder mehrere Verbindungen ausgewählt aus der folgenden Gruppe Di-2-ethylhexylsebacat (DOS), Di-2-ethylhexyladipat (DOA), Dihexyladipat (DHA), Dibutylsebacat (DBS), Triethylenglykol-bis-n-heptanoat (3G7), Tetraethylenglykol-bis-n-heptanoat (4G7), Triethylenglykol-bis-2-ethylhexanoat (3GO bzw. 3G8) Tetraethylenglykol-bis-n-2-ethylhexanoat (4GO bzw. 4G8) Di-2-butoxyethyladipat (DBEA), Di-2-butoxyethoxyethyladipat (DBEEA) Di-2-butoxyethylsebacat (DBES), Di-2-ethylhexylphthalat (DOP), Di-isononylphthalat (DINP) Triethylenglykol-bis-isononanoat, Triethylenglykol-bis-2-propylhexanoat, Tris(2-ethylhexyl)phosphat (TOF), 1,2-Cyclohexandicarbonsäurediisononylester (DINCH), Diisononyladipat (DINA) und Dipropylenglykolbenzoat.

Ganz besonders geeignet als Weichmacher für die erfindungsgemäßen Folien sind Weichmacher, deren Polarität, ausgedrückt durch die Formel 100 x O/(C+H) kleiner/gleich 9.4 ist, wobei O, C und H für die Anzahl der Sauerstoff-, Kohlenstoff- und Wasserstoffatome im jeweiligen Molekül steht. Die nachfolgende Tabelle zeigt erfindungsgemäß einsetzbare Weichmacher und deren Polaritätswerte nach der Formel 100 x O/(C+H).

| Name | Abkürzung | 100 x O/(C+H) |
|---|---|---|
| Di-2-ethylhexylsebacat | (DOS) | 5,3 |
| Di-iso-nonyladipat | (DINA) | 5,3 |
| 1,2-Cyclohexandicarbonsäurediisononylester | (DINCH) | 5,4 |
| Di-2-ethylhexyladipat | (DOA) | 6,3 |
| Dihexyladipat | (DHA) | 7,7 |
| Dibutylsebacat | (DBS) | 7,7 |
| Triethylenglykol-bis-2-propylhexanoat | | 8,6 |
| Triethylenglykol-bis-i-nonanoat | | 8,6 |
| Di-2-butoxyethylsebacat | (DBES) | 9,4 |
| Triethylenglykol-bis-2-ethylhexanoat | (3G8) | 9,4 |

Für die Verwendung in Photovoltaikmodulen weisen die erfindungsgemäßen Folien bei einer Umgebungsfeuchte von 85% rF bei 23°C bevorzugt einen spezifischen Widerstand von mindestens 1E+11 ohm*cm, bevorzugt mindestens 5E+11 ohm*cm, bevorzugt 1E+12 ohm*cm, bevorzugt 5E+12 ohm*cm, bevorzugt 1E+13, bevorzugt 5E+13 ohm*cm, bevorzugt 1E+14 ohm*cm auf.

Weiterhin können die erfindungsgemäßen Mischungen oder Folien zusätzlich weitere Additive, wie zum Beispiel Antistatika, Füllstoffe, IR-Absorbierende Nanopartikel bzw. Chromophore, Farbstoffe, oberflächenaktive Substanzen, Bleichmittel, Stabilisatoren, Säure/Base-Puffer, Chelatbildner, Epoxygruppen enthaltende Verbindungen, Pigmente sowie Haftungsregulatoren enthalten.

Insbesondere ist auch die Kombination mit selektiv IR-Strahlung reflektierenden oder absorbierenden Partikeln mit eingeschlossen.

Weiterhin ist Gegenstand der Erfindung die Verwendung von erfindungsgemäßen Folien zur Herstellung von Photovoltaikmodulen, Glaslaminaten, Gewächshausabdeckungen, im Möbelbereich, Vogelschutzverglasung insbesondere zur Anwendung
- In Gewächshausverglasung mit erhöhter Energietransmission und Durchlässigkeit für UV-A Strahlung.
- Als Verkapselungsfolie für Photovoltaikmodule mit erhöhter Photostromausbeute durch Nutzbarmachung des UV-A Anteils des Sonnenlichtspektrums
- Als Laminierfolie für besonders farbneutrale Architekturverglasung
- Als UV-Durchstrahlbares Verbundglas zu dessen Montage mit UV-A-härtenden Klebern, wie z.B. im Möbelglasbereich
- Als Teil einer Vogelschutzverglasung, bei welcher zur Erzielung eines UV-Kontrastes eine mit der PVB-Folie laminierte Scheibe partiell UV-durchlässig ist

Selbstverständlich sind auch Kombinationen der erfindungsgemäßen Folien mit hoher Transparenz für UV-A Strahlung mit konventionellen, weitgehend UV-opaken Folien in einem Bauteil denkbar und sinnvoll. Beispielsweise kann für den Anwendungsfall PV-Modul bei Einbettung von Solarzellen zwischen zwei Folienlagen die vordere auf der dem Licht zugewandten Seite befindliche Folie die beschriebene hohe Transparenz für UV-A Strahlung aufweisen, um damit die Energieausbeute zu erhöhen, die auf der Rückseite befindliche jedoch in gewohnter Weise für UV-B und UV-A Strahlung opak sein, damit dahinter befindliche Materialien, beispielsweise ein polymeres Backsheet oder eine aufgeklebte Kontaktdose vor UV-Schädigung geschützt wird oder aber im Fall eines in die Gebäudehülle integrierten Glas/Glas-Moduls der Gebäudeinnenraum vor UV-Strahlung geschützt bleibt.

Zur Erreichung von Farbneutralität kann bei Verwendung mehrerer Folienlagen, z.B. 3 x 0.76 mm, nur eine der Folienlagen mit konventionellem UV-Absorbern ausgerüstet sein, die beiden anderen jedoch mit den erfindungsgemäß verwendeten Oxanilid-Absorbern. Auf diese Weise lässt sich bei ausreichender UV-Absorption der Beitrag der PVB-Folie zum Gelbstich der Verglasung minimal halten.

Erfindungsgemäße Folien weisen in Stärke 0.76 mm bevorzugt einen Gelbwert db von weniger als 1, bevorzugt weniger als 0,7, besonders bevorzugt weniger als 0,5 und insbesondere weniger als 0,3 und einen delta b*-Wert von weniger als 5, bevorzugt weniger als 2,5, besonders bevorzugt weniger als 2 und insbesondere weniger als 1,5 auf.

Um im Fall von Gewächshausabdeckungen maximale Energietransmission bei gleichzeitigem Schutz gegen UV-B Strahlung zu erzielen, werden die erfindungsgemäßen Folie insbesondere mit eisenarmen Glas kombiniert. Dies kann bezogen auf das zur Lamination verwendetem Einzelglas eine Dicke von 1 bis 5 mm, vorzugsweise 1,5 bis 4 mm und am meisten bevorzugt 2 bis 3 mm aufweisen.

### Prüf- und Messmethoden:

Die Bestrahlungsbeständigkeit der Folien wurde im Verbundglas zwischen zwei Gläsern der Stärke 2 mm des Typs Optiwhite® (Eisenoxidarmes Glas der Firma Pilkington) getestet. Dabei wurden Laminate mit Abmessung 15 x 15 cm in der Bestrahlungskammer gemäß EN 12543 über einen Zeitraum von 20 Wochen ausgelegt. Abweichend von den Bedingungen der EN 12543 wurde eine höhere Probetemperatur von konstant 80 °C eingestellt, da dies eher einer in der Anwendung im ungünstigen Fall tatsächlich vorkommenden kombinierten Strahlungs- und Temperaturbelastung entspricht.

Durch vergleichende Messung des b*-Wertes (CIELab) des bestrahlten Laminates gegen ein dunkel gelagertes Originallaminat kann die relative Zunahme des b*-Wertes als Maß für die Strahlungsbeständigkeit der PVB-Folie mit dem jeweiligen Stabilisatortyp bzw. der jeweiligen Stabilisatorkombination ermittelt werden. Die Messung des b*-Wertes erfolgte auf einem Farbmessgerät "ColorQuest XE" des Herstellers Hunterlab im CIELAb-System in Transmission (10°/D65). Der delta b*-Wert ergibt sich als Differenz zwischen b*-Wert der bestrahlten Probe und dem b*-Wert der Originalprobe.

Zwecks Differenzierung der Eigenfarbe der extrudierten Folie (ohne zusätzliche Belastung durch Bestrahlung) wird ein Verbundglas mit Folie in Stärke 0.76 mm mit zwei Scheiben 2 mm Optiwhite auf dem ColorQuest XE in Einstellung Hunterlab 2°/C gemessen. Bei dem Verfahren wird die Eigenfarbe des Glases durch Einmessens des Scheibenpärchens der identischen Glascharge als Nullprobe herausgemittelt und der Beitrag der Zwischenschicht zur Gelbfärbung als Gelbwert db zahlenmäßig ermittelt.

Der Polyvinylalkohol- und Polyvinylalkoholacetatgehalt der Polyvinylacetale wurde gemäß ASTM D 1396-92 bestimmt. Die Analyse des Metallionengehaltes erfolgte durch Atomabsorptionsspektroskopie (AAS). Der Wasser- bzw. Feuchtegehalt der Folien wird mit der Karl-Fischer-Methode bestimmt.

Zur Bestimmung der UV-Absorption des in der Acetalisierung eingesetzten Polyvinylalkohols wird dieser in einem UV/VIS-Spektrometer, z.B. Perkin-Elmer Lambda 950, als 4%-ige wässrige Lösung in einer Schichtdicke von 1 cm bei der Wellenlänge 280 nm vermessen. Dabei ist der Messwert auf den Trockenstoffgehalt des PVA zu beziehen.

Die Strahlungstechnischen Eigenschaften (Lichttransmissionsgrad T L , Direkter Strahlungs transmissions grad TE, UV-Transmissionsgrad, Transmission bei angegebener Wellenlänge; jeweils ausgedrückt in %) der zwischen 2 x 2 mm Optiwhite laminierten Musterfolien wurde gemäß DIN EN 410 auf einem UV/VIS-Spektrometer Perkin-Elmer Lambda 950 bestimmt.

### Beispiele

Es wurden Folien mit den Mischungen der in den nachfolgenden Tabellen aufgeführten Zusammensetzungen und Dicken hergestellt und als Laminat zwischen 2 Scheiben Weißglas (Optiwhite) der Stärke 2 mm verarbeitet und untersucht.

Vergleichsbeispiel 1 (ohne UV- Stabilisator) zeigt eine zu hohe Transmission im UV-B-Bereich. Vergleichsbeispiel 3 eine zu niedrige Transmission im UV-A-Bereich. Vergleichsbeispiel 2 besitzt eine ausreichende niedrige bzw. hohe Transmission im UV-B- bzw. UV-A-Bereich, neigt aber aufgrund des phenolischen Antioxidants Irganox 1076 zur Vergilbung in der Bestrahlungsprüfung.

Die erfindungsgemäßen Folien gemäß Beispiel 1 - 9 zeigen eine hohe Transparenz für UV-A-Strahlung und sind daher für Anwendungen, die einen möglichst hohen Strahlungsanteil in diesem Wellenlängenbereich benötigen, gut geeignet.

Gleichzeitig ist die Absorption im UV-B-Bereich hoch (d.h. die Transmission niedrig) sodass ein ausreichender Schutz bzw. eine ausreichende Stabilisierung des Materials vor der hochenergetischen Strahlung in diesem Wellenlängenbereich gegeben ist. Dies wird durch die geringe Vergilbung im Bestrahlungstest deutlich.

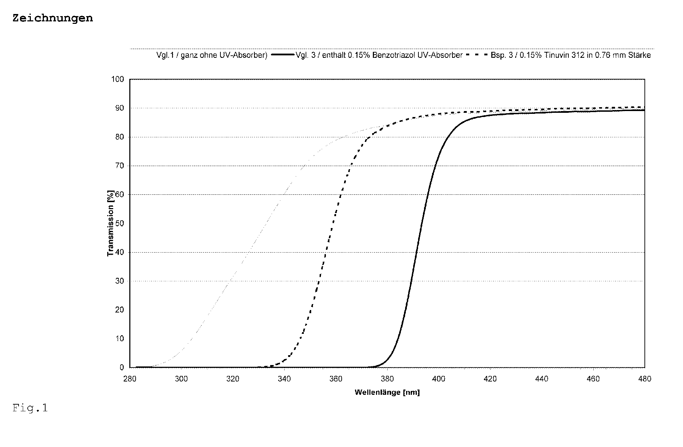

Fig.1 verdeutlicht die unterschiedlichen Transmissionsraten von Folien der Vergleichsbeispiele 1 (ohne UV- Stabilisator, keine ausreichende Absorption UV-B-Bereich), Vergleichsbeispiel 3 (zu niedrige Transmission im UV-A-Bereich) und Beispiel 3 (hohe Absorption im UV-B-Bereich bei hoher Transparenz für UV-A-Strahlung.

Es bedeuten in den Tabellen
- 3G8: Triethylenglykol-bis-2-ethylhexanoat
- DBEA: Di-2-butoxyethyladipat (ggf in Gew-Mischungsverhältnis mit 3G8
- DINCH: 1,2-Cyclohexandicarbonsäurediisononylester
- PVB: Polyvinylbutyral mit dem angegebenen PVA-Gehalt
- S 2450: Songnox 2450
- I 1076: Irganox 1076
- L 44B25: Lowinox 44B25
- S GA-80: Sumilizer GA-80
- TE: Direkte Strahlungstransmission TE (300-2500 nm) in %
- TL: Lichttransmission TL (380-780 nm) in %
- UV: UV-Transmission TUV (280-380 nm) in %
- Db*: Delta b*-Wert nach 20 Wochen Bestrahlungsprüfung in Anlehnung an EN 12543

- Tinuvin 328: Tinuvin 328 (Typ Benzotriazol UV-Absorber)
- Tinuvin 312: Tinuvin 312 (Typ Oxanilid UV-Absorber)
- Laminatprüfung: Prüfwerte im Laminat zwischen 2 x 2 mm Optiwhite Glas

- Gelbwert db: Gelbwert db Colorquest XE

- ng: nicht geprüft

(a) Angaben in Gew% bezogen auf PVB
(b) Angaben in ppm bezogen auf PVB
(c) Angaben in Gew% bezogen auf die Folie

**Tabelle 1**

| | Vgl. 1 | Vlg.2 | Vgl. 3 |
|---|---|---|---|
| Foliendicke in mm | 0.76 | 0.76 | 0.76 |
| PVOH-Gehalt des PVB ^{(a)} | 19, 8 | 20, 1 | 19, 8 |
| Gehalt Antioxidants in PVB^{(b)} | 800 | 800 | 800 |
| Antioxidants Typ | S 2450 | I 1076 | S 2450 |
| PVB^{(c)} | 72,5 | 72,5 | 72,5 |
| 3G8/DBEA 10:1^{(c)} | 27,5 | 27,5 | 27,5 |
| DINCH^{(c)} | - | - | - |
| MgAc₂ * 4 H₂O^{(c)} | 0,015 | 0,015 | 0,015 |
| Songlight 2920 (HALS) ^{(c)} | | | |
| Tinuvin 328^{(c)} | | | 0,15 |
| Tinuvin 312^{(c)} | | 0,15 | |
| Laminatprüfung | | | |
| Gelbwert db | 0,25 | 0,29 | 0,40 |
| TE % | 86,5 | 84,8 | 82,6 |
| TL % | 90,1 | 90,2 | 89,6 |
| UV % | 64,2 | 28,9 | 0,1 |
| % Transmission 325 nm | 38,4 | 0,1 | 0 |
| % Transmission 380 nm | 84,2 | 79,2 | 2,7 |
| Db* | 3, 4 | 8, 8 | 0, 4 |

**Tabelle 2**

| | Bsp.1 | Bsp.2 | Bsp.3 | Bsp.4 | Bsp.5 | Bsp.6 | Bsp.7 | Bsp.8 | Bsp.9 |
|---|---|---|---|---|---|---|---|---|---|
| Foliendicke in mm | 0.38 | 0.38 | 0.76 | 0.38 | 0.76 | 0.76 | 0.76 | 0.76 | 0.76 |
| PVOH-Gehalt des PVB^{(a)} | 19,8 | 19,8 | 19,8 | 19,8 | 20 | 19,9 | 20 | 15,2 | 19,9 |
| Gehalt Antioxidants^{(b)} | 800 | 800 | 800 | 800 | 800 | 1100 | 800 | 800 | 1100 |
| Antioxidants Typ | S 2450 | S 2450 | S 2450 | S 2450 | L44B25 | BHT | S GA-80 | S 2450 | BHT |
| PVB^{(c)} | 72,5 | 72,5 | 72,5 | 72,5 | 72,5 | 72,5 | 72,5 | 74 | 72,5 |
| 3G8/DBEA 10:1^{(c)} | 27,5 | 27,5 | 27,5 | 27,5 | 27,5 | 27,5 | 27,5 | - | 27,5 |
| DINCH^{(c)} | - | - | - | - | - | - | - | 26 | - |
| MgAc2 * 4 H2O^{(c)} | 0,015 | 0,015 | 0,015 | 0,015 | 0,015 | 0,015 | 0,015 | 0,015 | 0,015 |
| Songlight2920 (HALS) ^{(c)} | | | | | | | | | 0,10 |
| Tinuvin 328^{(c)} | | | | | | | | | |
| Tinuvin 312^{(c)} | 0,05 | 0,10 | 0,15 | 0,20 | 0,15 | 0,15 | 0,15 | 0,15 | 0,15 |
| Laminatprüfung | | | | | | | | | |
| Gelbwert db | 0,10 | 0,10 | 0,23 | 0,10 | 0,20 | 0,23 | 0,21 | 0,16 | 0,20 |
| TE % | 87,1 | 86,7 | 85,2 | 86,4 | 85,3 | 85,2 | 85,4 | 85,3 | 85,1 |
| TL % | 91,0 | 90,9 | 90,5 | 90,9 | 90,4 | 90,3 | 90,5 | 90,8 | 90,2 |
| UV % | 56,6 | 48,9 | 32,5 | 40,4 | 31,7 | 33,6 | 34,5 | 33,0 | 34,2 |
| % Transmission 325 nm | 15,8 | 5,3 | 0,1 | 0, 6 | 0,1 | 0,1 | 0,1 | 0,1 | 0,1 |
| % Transmission 380 nm | 87,9 | 87,6 | 83,8 | 87,3 | 83,2 | 83,8 | 83,6 | 83,4 | 83,4 |
| Db* | ng | ng | 1,2 | ng | 4,3 | 0,9 | 1,1 | 0,8 | 0,4 |

## Patentansprüche

1. Folie enthaltend mindestens ein Polyvinylacetal und mindestens einen Weichmacher, **gekennzeichnet durch** den Zusatz von 0,001 bis 1 Gew.% mindestens einer Verbindung vom Oxanilid-Typ gemäß Formel (1) 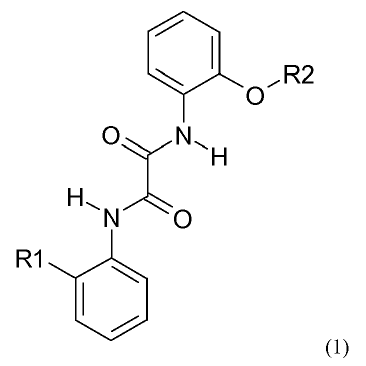 mit R1, R2 = Kohlenwasserstoffradikal mit 1 bis 10 Kohlenstoffatomen als UV-Absorber.

2. Folie nach Anspruch 1, **dadurch gekennzeichnet, dass** als UV-Absorber der Formel 1 solche der CAS-Reg.Nr. 23949-66-8 eingesetzt werden.

3. Folie nach einem der Ansprüche 1 oder 2, **dadurch gekennzeichnet, dass** die Folie nicht mehr als 1000 ppm an phenolischen Antioxidantien enthalten, welche die Teilstruktur (2,5-di-tert-butyl-4-hydroxyphenyl)propionat aufweisen.

4. Folie nach einem der Ansprüche 1 bis 3, **dadurch gekennzeichnet, dass** die Folie einen Alkalititer von 2 - 70 aufweist.

5. Folie nach einem der Ansprüche 1 bis 4, **dadurch gekennzeichnet, dass** die Folie 0,001 bis 1 Gew.% mindestens einer Verbindung gemäß Formel (2) 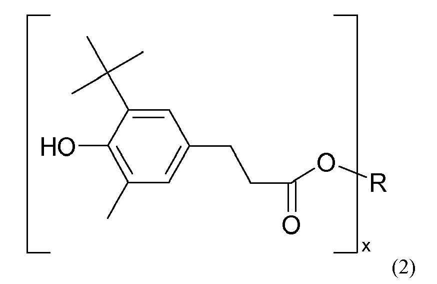 mit R= Kohlenwasserstoffradikal eines polyfunktionellen Alkohols, bifunktionellem cyclischem Ether, bifunktionellem cyclischem Diether, bifunktionellem Dioxanderivat, Oligoglykole mit 1 bis 10 Glykoleinheiten oder Kohlenwasserstoffrest mit 1 bis 20 Kohlenstoffatomen und X= 1, 2, 3 oder 4 enthält.

6. Folie nach einem der Ansprüche 1 bis 5, **dadurch gekennzeichnet, dass** die Folie phenolische Antioxidantien mit einem Molekulargewicht von weniger als 300 g/mol in einer Menge von 0.005 - 0.5 Gew.% enthält.

7. Folie nach einem der Ansprüche 1 bis 6, **dadurch gekennzeichnet, dass** die Folie 0,001 bis 1 Gew.% nichtaromatische Lichtstabilisatoren von HAS/HALS/NOR-HALS-Typ enthält.

8. Folie nach einem der Ansprüche 1 bis 7, **dadurch gekennzeichnet, dass** die Folie einen delta b* - Wert von weniger als 3 besitzt.

9. Folie nach einem der Ansprüche 1 bis 8, **dadurch gekennzeichnet, dass** die Folie einenGelbwert db von weniger als 1 aufweist.

10. Folie nach einem der Ansprüche 1 bis 9, **dadurch gekennzeichnet, dass** das Polyvinylacetal durch Acetalisierung von Polyvinylalkohol hergestellt wird, der in einer 4 Gew.% wässrigen Lösung eine Extinktion bei 280 nm von weniger als 0,5 aufweist.

11. Folie nach einem der Ansprüche 1 bis 10, **dadurch gekennzeichnet, dass** die Folie mehr als 5 ppm Metallionen ausgewählt aus der Gruppe Erdalkalimetalle, Zink, und Aluminium und weniger als 150 ppm Alkalimetallionen aufweist.

12. Folie nach einem der Ansprüche 1 bis 11, **dadurch gekennzeichnet, dass** die Folie zusätzlich phenolische Antioxidantien welche die Teilstruktur (2,5-di-tert-butyl-4-hydroxyphenyl)propionat nicht enthalten in einer Menge von 0,005-0,5 Gew.% enthalten.

13. Verwendung einer Folie nach einem der Ansprüche 1 bis 12, zur Herstellung von Photovoltaikmodulen, Gewächshausabdeckungen, Glaslaminaten im Möbelbereich, farbarmer Verglasung, Vogelschutzverglasung.
